# EUROPÄISCHE PATENTSCHRIFT

(11) **EP 0 831 077 B1**
(45) Veröffentlichungstag und Bekanntmachung des Hinweises auf die Patenterteilung: **24.10.2001**
(21) Anmeldenummer: 96114972.1
(22) Anmeldetag: 18.09.1996
(51) Int. Cl.: C04B 41/87, C04B 41/89, H01L 31/18, H01L 31/042

(54) **Keramisches Substrat für kristalline Silicium-Dünnschicht-Solarzellen**
Ceramic substrate for crystalline silicon thin layer solar cells
Substrat céramique pour éléments à couche mince d'une batterie solaire en silicium cristallin

(43) Veröffentlichungstag der Anmeldung: 25.03.1998
(73) Patentinhaber: TeCe Technical Ceramics GmbH & Co. KG, 95100 Selb (DE)
(72) Erfinder: Räuber, Armin Dr., 79194 Gundelfingen (DE); Eyer, Achim Dr., 79104 Freiburg (DE); Pohlmann, Hans-Jürgen Dr.-Ing., 95100 Selb (DE)
(74) Vertreter: Weiss, Wolfgang, Dipl.-Chem. Dr.

(56) Entgegenhaltungen:
- EP-A- 0 536 682
- DATABASE WPI Week 9401 Derwent Publications Ltd., London, GB; AN 94-003358 XP002021896 "Forming polysilicon thin film for solar cell" & JP-A-05 315 259 (TONEN CORP.) , 26.November 1993
- A. EYER ET AL.: "Die kristalline Silicium-Dünnschichtzelle auf industrierelevanten Substraten", FORSCHUNGSVERBUND SONNENENERGIE THEMEN 95/96, , , Band , Nr. , Seiten 76 - 80

## Beschreibung

Die Erfindung betrifft die Herstellung einer Trägerscheibe für ein Solarzelle, die ein schichtförmiges keramisches Substrat auf Basis von reaktionsgebundenem Siliciumcarbid, insbesondere von Silicium-infiltriertem reaktionsgebundenem Siliciumcarbid, eine Deckschicht aus kristallinem Silicium und gegebenenfalls eine dazwischen angeordnete Sperrschicht umfaßt sowie eine durch das Verfahren erhältliche Trägerscheibe.

Der überwiegende Anteil der zur Zeit auf dem Markt erhältlichen Solarzellen besteht aus einer mit Bor dotierten Siliciumplatte, in die eine durch Diffusion erzeugte Phosphordotierung für den erforderlichen pn-Übergang eingebracht wurde sowie aus den zur Stromleitung notwendigen Leiterbahnen und elektrischen Anschlußelementen. Ein entscheidender Nachteil dieser kompakten Siliciumsolarzellen sind die hohen Materialpreise für die dotierten Siliciumscheiben (Wafer), die in der Regel durch Sägen von gezogenen oder gegossenen Siliciumblöcken oder von Einkristallen erzeugt werden. Der beim Sägen auftretende Verlust kann bis zu 70% des eingesetzten Siliciums betragen.

Als ausschlaggebend für einen breiteren Einsatz von Solarzellen wird eine Senkung der für die Herstellung benötigten Kosten angesehen. Da das dafür notwendige Einsparpotential bei den herkömmlichen kompakten Siliciumsolarzellen derzeit nicht erkennbar ist, wird nach Alternativlösungen gesucht. Dabei wird derzeit die kristalline Silicium-Dünnschicht-Solarzelle als ein erfolgsversprechender Weg angesehen.

Solche Dünnschicht-Solarzellen enthalten ein Substrat und eine darauf aufgebrachte dünne Schicht aus Bor-dotiertem Silicium. Dabei ist der Materialeinsatz an teurem Halbleitermaterial gering, es stehen viele Herstellverfahren für Schichttechniken zur Verfügung und die Solarzellen lassen sich schon beim Herstellprozeß leicht zu größeren Einheiten integrieren. Als mögliche Substratmaterialien werden unter anderem Graphit, Siliciumcarbid, Siliciumnitrid und Mullit genannt. Ein Nachteil bei Verwendung von Siliciumcarbid besteht darin, daß billige Massenproduktionsverfahren für solche Substrate derzeit noch nicht vorhanden sind (vgl. Eyer et al. "Die kristalline Silicium-Dünnschichtzelle auf Industrie-relevanten Substraten" in Forschungsverbund Sonnenenergie "Themen 95/96", 76 - 80).

Keramische Werkstoffe der Phasenzusammensetzung SiC-C-Si sind aus dem Stand der Technik bekannt. So beschreibt DE 16 71 092 ein keramisches Material, das aus einer Rohmischung von 50% SiC 0 - 100 *µ*m, 30% Ruß und 20% Silicium hergestellt wird. In den US-Patentschriften 3,079,273 und 2,938,807 sowie in GB-A-866813 wird die Herstellung von reaktionsgebundenem, durch Siliciuminfiltration erzeugtem Siliciumcarbid beschrieben.

Die der vorliegenden Erfindung zugrundeliegende Aufgabe bestand darin, die Herstellkosten von keramischen Substraten für Solarzellen zu verringern. Überraschenderweise wurde festgestellt, daß bei der Verwendung von Substraten der Phasenzusammensetzung SiC-C-Si und dem Aufschmelzen einer auf das keramische Substrat aufgebrachten Siliciumschicht die Reaktionsbindung Si + C → SiC im keramischen Substrat gleichzeitig mit dem Aufschmelzen der aufgebrachten Siliciumschicht erfolgen kann und der Prozeß durch die auftretende Reaktionswärme vorteilhaft unterstützt wird. Mit diesem erfindungsgemäßen Verfahrensschritt wird ein separater keramischer Brand überflüssig und ein wesentlicher Teil der üblichen Herstellungskosten für die Keramik eingespart.

Das erfindungsgemäß hergestellte Keramiksubstrat kann in einem breiten Zusammensetzungsbereich hergestellt werden und erfüllt die Anforderungen hinsichtlich Festigkeit, Wärmeausdehnung, elektrische Leitfähigkeit und Haftung der Siliciumdeckschicht in hervorragender Weise. Die Verunreinigung von Oberflächensilicium durch Stoffe aus dem Substratmaterial kann durch Verwendung von entsprechend reinen Rohstoffen oder/und durch Aufbringen von Sperrschichten vermieden werden.

Ein Gegenstand der vorliegenden Erfindung ist somit ein Verfahren zur Herstellung einer Trägerscheibe für eine Solarzelle, die eine keramische Substratschicht auf Basis von Silicium-infiltriertem reaktionsgebundenem Siliciumcarbid, eine Deckschicht aus kristallinem Silicium und gegebenenfalls eine dazwischen angeordnete Sperrschicht umfaßt, welches dadurch gekennzeichnet ist, daß man die Reaktionsbindung der Substratschicht und die Ausbildung der Siliciumdeckschicht in einem einzigen Wärmebehandlungsschritt gleichzeitig durchführt.

Wie bereits ausgeführt, kann die keramische Substratschicht in einem breiten Zusammensetzungsbereich im System SiC-C-Si hergestellt werden. Sie kann neben dem Siliciumcarbid auch noch freien Kohlenstoff oder/und freies Silicium enthalten. Das durch Reaktionsbindung in der keramischen Substatschicht neu gebildete SiC kann sich auf dem bereits in der Rohmischung enthaltenden Kohlenstoff oder SiC abscheiden und dieses zu einem stabilen keramischen Körper verkitten. Weiterhin kann die keramische Substratschicht auch ein nicht mit dem Kohlenstoff reagiertes überschüssiges Silicium enthalten, wodurch eine elektrische Leitfähigkeit erzeugt wird.

Die Herstellung der keramischen Substratschicht erfolgt vorzugsweise durch Foliengießen. Diese Technik ist beispielsweise in den Patentschriften US 3,079,273 und DE 22 56 326 beschrieben. Hierbei werden die keramischen Rohstoffe in Pulverform gegebenenfalls unter Zusatz von Bindemitteln wie etwa Phenolharz in eine Kunststoffolie, z.B. Polyvinylbutyral, eingebettet und in einem ersten Wärmebehandlungsschritt in nichtoxidierender Atmosphäre "verkokt", um die organischen Bestandteile zu zersetzen. Darüberhinaus können zur Herstellung der keramischen Substate auch bekannte Verfahren wie Stanzen oder Laminieren sowie das Herstellen von mehrschichtig gegossenen Folien oder Verdichtungsverfahren (Kalandrieren) angewendet werden.

Die Dicke der keramischen Substratschicht beträgt vorzugsweise 0,3 - 3 mm und besonders bevorzugt 0,5 - 1 mm. Substratschichten mit einer Dicke von mehr als 1 mm werden vorzugsweise durch Laminierung von mehreren Kunststoffolien hergestellt.

Ein wesentliches Merkmal des erfindungsgemäßen Verfahrens besteht darin, daß die Ausbildung der Siliciumdeckschicht und die Reaktionsbindung in der keramischen Substratschicht in einem einzigen Wärmebehandlungsschritt gleichzeitig durchgeführt werden. Dieser Wärmebehandlungsschritt umfaßt vorzugsweise ein Erhitzen auf eine Temperatur von etwa 1450°C in einer inerten Atmosphäre, z.B. einer Wasserstoff/Argon-Atomosphäre oder/und unter Vakuum. Vorzugsweise wird der Wärmebehandlungsschritt als Zonenschmelzprozeß durchgeführt, wobei das Silicium der Deckschicht als grobkristallines Silicium entsteht, das eine Korngröße vorzugsweise bis zu 1 mm haben kann. Dabei ist die laterale Ausdehnung der Körner vorzugsweise größer, z.B. 5 - 10 mal so groß, als deren Höhe. Auf diese Deckschicht kann anschließend durch epitaktisches Aufwachsen, z.B. aus der Gasphase die eigentliche photoaktive Schicht abgeschieden werden.

Das Silicium der Deckschicht ist vorzugsweise ein hochdotiertes Silicium in Halbleiterqualität, d.h. ein mit etwa 10¹⁸ - 10¹⁹ Atomen Bor pro cm³ dotiertes Silicium, das maximal 0,1 ppb metallische Verunreinigungen enthält. Die Dicke der Siliciumdeckschicht beträgt vorzugsweise 2 - 500 *µ*m, besonders bevorzugt 5 - 200 *µ* m und am meisten bevorzugt 10 - 100 *µ*m.

Auf diese Siliciumdeckschicht wird anschließend die photovoltaisch aktive Siliciumschicht mit einer Dicke von vorzugsweise 5 - 200 *µ*m und besonders bevorzugt von 5 - 50 *µ*m aufgebracht. Diese Schicht kann aus der Gasphase oder aus der Lösung abgeschieden werden. Für die Abscheidung aus der Gasphase stehen verschiedene Techniken zur Verfügung, z.B. LPCVD (Low Pressure Chemical Vapor Deposition), APCVD (Atmospheric Pressure Chemical Vapor Deposition) oder PECVD (Plasma Enhanced Chemical Vapor Deposition). Die Abscheidetemperatur läßt sich in weiten Bereichen, z.B. 200 - 1400°C, variieren. Ausgangsmaterialien sind Silan oder/und verschiedene Chlorsilane. Für die Abscheidung aus der Lösung werden verschiedene Metallschmelzen, z.B. In, Ga, Sn etc. benutzt. Auch hier steht ein weiter Temperaturbereich von etwa 30 - 1200°C zur Verfügung.

Der pn-Übergang kann entweder wie bei klassischen Si-Solarzellen durch Eindiffusion von entsprechenden Dotierstoffen, vorzugsweise Phosphor, oder durch Abscheiden einer entsprechend dotierten Schicht auf der meist Bor-dotierten Basisschicht erzeugt werden.

Obwohl ein direktes Aufbringen der Siliciumdeckschicht auf die keramische Substratschicht möglich ist, kann zwischen dem Substrat und dem Silicium auch eine zusätzliche Passivierungs- oder Sperrschicht aufgebracht werden. Das Material der Sperrschicht, die eine Dicke von vorzugsweise 1 - 100 *µ*m und besonders bevorzugt von 2 - 50 *µ*m aufweist, wird vorzugsweise aus der Gruppe bestehend aus SiO₂, TiN, Si₃N₄, BC und Metallsiliciden, beispielsweise Molybdän- oder Wolframsiliciden, ausgewählt.

Weiterhin kann die durch das erfindungsgemäße Verfahren hergestellte Trägerscheibe durch Strukturierung der Grenzflächen, z.B. durch Texturierung der Oberflächen von Substrat- oder Siliciumschicht, so ausgestaltet werden, daß durch Reflexion eine Lichtwegerhöhung eintritt.

Die Weiterverarbeitung der durch das erfindungsgemäße Verfahren hergestellten Trägerscheiben zu Solarzellen kann auf bekannte Weise erfolgen.

Noch ein weiterer Gegenstand der vorliegenden Erfindung ist eine durch das oben beschriebene Verfahren erhältliche Trägerscheibe für Solarzellen. Diese Trägerscheibe umfaßt:
(a) ein schichtförmiges keramisches Substrat auf Basis von, insbesondere Siliciuminfiltriertem, reaktionsgebundenem Siliciumcarbid,
(b) eine Deckschicht aus kristallinem Silicium und
(c) gegebenenfalls eine zwischen Substrat- und Deckschicht angeordnete Sperrschicht.

Vorzugsweise weist die keramische Substratschicht ein dichtes Gefüge auf und enthält neben Siliciumcarbid auch noch freien Kohlenstoff oder/und freies metallisches Silicium. Das Siliciumcarbid und der Kohlenstoff liegen - sofern vorhanden - vorzugsweise in Form von Partikeln mit einem mittleren Durchmesser von 0,1 bis 20 *µ*m vor.

Weiterhin soll die vorliegende Erfindung durch die nachfolgenden Beispiele erläutert werden. Alle Prozentangaben bedeuten Gewichtsprozent.

### BEISPIELE

### Beispiel 1:

Es wird in bekannter Weise durch Bandgießen eine keramische Folie hergestellt, die ein Rohstoffpulvergemisch, bestehend aus 60 Gew.-% Siliciumcarbid, 10% Kohlenstoff und 30% Silicium, enthält. Die Folie wird zu quadratischen 10 cm x 10 cm Substratplatten gestanzt. Die Platten werden in einem ersten Wärmebehandlungsschritt in nichtoxidierender Atmosphäre bis auf 800°C erhitzt, um die organischen Bindemittel zu zersetzen. Dann wird gepulvertes, mit 10¹⁸ Atomen Bor pro cm³ dotiertes Silicium in Halbleiterqualität in einer Menge, um eine 50 *µ*m dicke Auflage zu ergeben, auf das Substrat gestreut. Das bestreute Substrat wird einem zweiten Wärmebehandlungsschritt bei etwa 1400 - 1450°C unterworfen. Dieser Wärmebehandlungsschritt kann beispielsweise mittels Zonenschmelzen durchgeführt werden. Dabei schmilzt neben dem auf das Substrat gestreute Silicium auch das im Substrat selbst befindliche Silicium, das mit dem Kohlenstoff zu Siliciumcarbid reagiert. Dieser Reaktionsprozeß verläuft exotherm und unterstützt damit die gleichmäßige Durchwärmung des Substrats. Das im Substrat neu gebildete Siliciumcarbid scheidet sich vorzugsweise auf der Oberfläche des in der Rohmischung enthaltenen Siliciumcarbids ab und verkittet dies zu einem stabilen keramischen Körper. Das bei dem Prozeß nicht mit Kohlenstoff reagierende überschüssige Silicium bedeckt die Oberfläche des entstehenden keramischen Substrats und macht es elektrisch leitfähig.

Auf diese Weise entsteht eine Trägerscheibe für eine Solarzelle, umfassend eine keramische Substratschicht, die Siliciumcarbid, sowie gegebenenfalls Kohlenstoff und Silicium enthält. Auf dieser keramischen Substratschicht ist eine dünne grobkristalline Deckschicht aus Silicium aufgeschmolzen.

### Beispiel 2:

Entsprechend Beispiel 1 wird durch Bandgießen eine mit Siliciumcarbid, Kohlenstoff und Silicium gefüllte Kunststoffolie hergestellt. Auf diese Folie wird in einem zweiten Gießvorgang eine Folienschicht aufgetragen, die hochdotiertes Silicium enthält. Aus dieser zweischichtigen Folie werden Substratplatten gestanzt, nachdem gegebenenfalls ein Verdichtungsschritt durch Kalandrieren erfolgt ist.

Anschließend erfolgen entsprechend Beispiel 1 zwei Wärmebehandlungsschritte, wobei die Folien zunächst zur Zersetzung der organischen Bindemittel "verkokt" und dann auf ca. 1400 - 1450°C aufgeheizt werden, um das Silicium zu schmelzen. Das mit dem Kohlenstoff umgebene Silicium reagiert dabei zu Siliciumcarbid. Das Silicium der oberen Folienschicht schmilzt und vermischt sich nicht mit dem in der Trägerschicht befindlichen Silicium.

Auf diese Weise wird eine keramische Substratschicht mit einer darauf befindlichen kristallinen Siliciumschicht erhalten.

### Beispiel 3:

In Abänderung der in Beispiel 1 und 2 beschriebenen Vorgehensweise werden keramische Folien hergestellt, die 25% Kohlenstoff und 75% Silicium, 20% Kohlenstoff und 80% Silicium bzw. 15% Kohlenstoff und 85% Silicium enthalten. Diese keramischen Folien werden entsprechend der in Beispiel 1 oder Beispiel 2 angegebenen Vorgehensweise zu einer Trägerscheibe verarbeitet. Die keramische Substratschicht dieser Trägerscheibe enthält Siliciumcarbid sowie Reste von nichtreagiertem Kohlenstoff und Silicium.

### Beispiel 4:

In Abänderung der in den Beispielen 1 - 3 beschriebenen Vorgehensweise wird die keramische Substratschicht mit einer Sperrschicht versehen, die eine eventuelle Diffusion von Verunreinigungen aus dem Substrat in die darauf aufgebrachte Siliciumdeckschicht wirksam verhindert. Diese Sperrschicht wird nach Verkoken des keramischen Substrats mit Hilfe bekannter Abscheidetechniken wie CVD oder Sol-Gel-Verfahren auf das Substrat aufgebracht. Die Sperrschicht hat eine Dicke von 25 *µ*m und kann aus SiO₂, TiN, Si₃N₄, BC oder Metallsiliciden bestehen.

Auf die Sperrschicht wird wie in Beispiel 1 oder 2 beschrieben hochdotiertes Silicium in Halbleiterqualität in Form eines Pulvers oder einer Folie aufgebracht. Dann wird ein Wärmebehandlungsschritt mittels Zonenschmelzen durchgeführt, wobei eine grobkristalline Siliciumschicht auf der Sperrschicht gebildet wird. Es entsteht eine Trägerscheibe, die zwischen der keramischen Substrat- und der Siliciumdeckschicht zusäztlich eine Sperrschicht enthält.

### Beispiel 5:

Entsprechend den vorstehenden Beispielen wird eine keramische Folie hergestellt, die nur hochreinen Kohlenstoff in Pulverform enthält. Auf diese keramische Folie wird Silicium aufgestreut oder in Form einer zweiten Folienschicht aufgebracht.

Beim Wärmebehandlungsschritt wird ein Teil des geschmolzenen Siliciums durch Reaktion mit dem Kohlenstoff zu Siliciumcarbid umgewandelt und bildet einen stabilen keramischen Körper. Entsprechende Ergebnisse werden erhalten, wenn eine keramische Folie aus Kohlenstoff und Siliciumcarbid verwendet wird.

## Patentansprüche

1. Verfahren zur Herstellung einer Trägerscheibe für eine Solarzelle, die eine keramische Substratschicht auf Basis von reaktionsgebundenem Siliciumcarbid, eine Deckschicht aus kristallinem Silicium und gegebenenfalls eine dazwischen angeordnete Sperrschicht umfaßt,
**dadurch gekennzeichnet,**
**daß** man die Reaktionsbindung der Substratschicht und die Ausbildung der Siliciumdeckschicht in einem einzigen Wärmebehandlungsschritt gleichzeitig durchführt.

2. Verfahren nach Anspruch 1,
**dadurch gekennzeichnet,**
**daß** die keramische Substratschicht nach dem Reaktionsbrand neben Siliciumcarbid noch freien Kohlenstoff oder/und freies Silicium enthält.

3. Verfahren nach Anspruch 1 oder 2,
**dadurch gekennzeichnet,**
**daß** das Silicium der Deckschicht als grobkristallines Silicium entsteht.

4. Verfahren nach einem der Ansprüche 1 - 3,
**dadurch gekennzeichnet,**
**daß** die Dicke der Substratschicht 0,3 - 3 mm und vorzugsweise 0,5 - 1 mm beträgt.

5. Verfahren nach einem der Ansprüche 1 - 4,
**dadurch gekennzeichnet,**
**daß** die Dicke der Siliciumdeckschicht 2 - 500 *µ*m und vorzugsweise 5 - 200 *µ*m beträgt.

6. Verfahren nach einem der Ansprüche 1 - 5,
**dadurch gekennzeichnet,**
**daß** das Silicium der Deckschicht ein mit etwa 10¹⁸ - 10¹⁹ Atomen Bor pro cm³ dotiertes Silicium in Halbleiterqualität ist.

7. Verfahren nach einem der Ansprüche 1 - 6,
**dadurch gekennzeichnet,**
**daß** die Trägerscheibe zwischen Substrat- und Siliciumdeckschicht eine Sperrschicht enthält.

8. Verfahren nach Anspruch 7,
**dadurch gekennzeichnet,**
**daß** das Material der Sperrschicht ausgewählt wird aus der Gruppe bestehend aus SiO₂, TiN, Si₃N₄, BC und Metallsiliciden.

9. Trägerscheibe für eine Solarzelle, umfassend
(a) ein schichtförmiges keramisches Substrat auf Basis von reaktionsgebundenem Siliciumcarbid,
(b) eine Deckschicht aus kristallinem Silicium und
(c) gegebenenfalls eine zwischen Substrat- und Deckschicht angeordnete Sperrschicht.

10. Verwendung einer Trägerscheibe nach Anspruch 9 oder erhältlich durch ein Verfahren nach einem der Ansprüche 1 bis 8 zur Herstellung von kristallinen Silicium-Dünnschicht-Solarzellen.

## Claims

1. A method of producing a support wafer for a solar cell, which comprises a ceramic substrate layer based on reaction-bound silicon carbide, a surface layer of crystalline silicon and, optionally, a barrier layer arranged therebetween, **characterised in that** the reaction bonding of the substrate layer and the formation of the silicon surface layer are carried out simultaneously in a single heat-treatment step.

2. A method according to Claim 1, **characterised in that** after the reaction firing the ceramic substrate layer still contains, in addition to silicon carbide, free carbon and/or free silicon.

3. A method according to Claim 1 or 2, **characterised in that** the silicon of the surface layer is formed as a coarse crystalline silicon.

4. A method according to any one of Claims 1 to 3, **characterised in that** the thickness of the substrate layer is 0.3 to 3 mm and, preferably, 0.5 to 1 mm.

5. A method according to any one of Claims 1 to 4, **characterised in that** the thickness of the silicon surface layer is 2 to 500 µm and, preferably, 5 to 200 µm.

6. A method according to any one of Claims 1 to 5, **characterised in that** the silicon of the surface layer is a silicon of semiconductor quality doped with approximately 10¹⁸ to 10¹⁹ atoms of boron per cm^{3.}

7. A method according to any one of Claims 1 to 6, **characterised in that** the support wafer contains a barrier layer between the substrate layer and the silicon surface layer.

8. A method according to Claim 7, **characterised in that** the material of the barrier layer is chosen from the group comprising SiO₂, TiN, Si₃N₄, BC and metal silicides.

9. A support wafer for a solar cell, comprising
(a) a laminated ceramic substrate based on reaction-bound silicon carbide,
(b) a surface layer of crystalline silicon and
(c) optionally, a barrier layer disposed between the substrate layer and surface layer.

10. Use of a support wafer according to Claim 9 or which can be obtained by a method according to any one of Claims 1 to 8 for the production of crystalline silicon thin-film solar cells.

## Revendications

1. Procédé pour la préparation d'un disque porteur pour une cellule solaire qui comprend une couche de substrat céramique à base de carbure de silicium lié par réaction, une couche de revêtement en silicium cristallin et éventuellement une couche de barrage disposée entre celles-ci,
**caractérisé en ce que**,
l'on conduit la liaison par réaction de la couche de substrat et la formation de la couche de silicium simultanément en une étape unique de traitement thermique.

2. Procédé selon la revendication 1,
**caractérisé en ce que**,
après la cuisson réactionnelle, la couche de substrat céramique contient encore du carbone libre ou/et du silicium libre en plus du carbure de silicium.

3. Procédé selon la revendication 1 ou 2,
**caractérisé en ce que**,
le silicium de la couche de revêtement est produit comme silicium cristallin grossier.

4. Procédé selon l'une des revendications 1-3,
**caractérisé en ce que**,
l'épaisseur de la couche de substrat est 0,3-3 mm et de préférence 0,5-1 mm.

5. Procédé selon l'une des revendications 1-4,**caractérisé en ce que**,
l'épaisseur de la couche de revêtement de silicium est 2-500 µm et de préférence 5-200 µm.

6. Procédé selon l'une des revendications 1-5,
**caractérisé en ce que**,
le silicium de la couche de revêtement est un silicium de qualité pour semi-conducteurs, doté d'environ 10¹⁸ - 10¹⁹ atomes de bore par cm³.

7. Procédé selon l'une des revendications 1-6,
**caractérisé en ce que**,
le disque porteur contient une couche de barrage entre la couche de substrat et la couche de revêtement de silicium.

8. Procédé selon la revendication 7,
**caractérisé en ce que**,
le matériau de la couche de barrage est sélectionné à partir du groupe constitué par SiO2, TiN, Si3N4, BC et les silicides métalliques.

9. Disque porteur pour une cellule solaire, comprenant
(a) un substrat céramique en forme de couche à base de carbure de silicium lié par réaction,
(b) une couche de revêtement à partir de silicium cristallin et
(c) éventuellement une couche de barrage disposée entre la couche de substrat et de revêtement.

10. Utilisation d'un disque porteur selon la revendication 9 ou pouvant être obtenu par un procédé selon l'une des revendications 1 à 8 pour la préparation de cellules solaires à couches minces de silicium cristallin.
